# FASCICULE DE BREVET EUROPEEN

(11) **EP 0 611 235 B1**
(45) Date de publication et mention de la délivrance du brevet: **10.04.1996**
(21) Numéro de dépôt: 94420046.8
(22) Date de dépôt: 11.02.1994
(51) Int. Cl.: H01L 23/473

(54) **Echangeur de chaleur pour composants électroniques et appareillages électrotechniques**
Wärmeaustauscher für elektronische Bauteile und elektrische Apparate
Heat exchanger for electronic components and electrical apparatus

(30) Priorité: 12.02.1993 FR 9301870
(43) Date de publication de la demande: 17.08.1994
(73) Titulaire: FERRAZ Société Anonyme, F-69003 Lyon (FR)
(72) Inventeur: Julien, Jean-Noel, F- 30300 Beaucaire (FR); Ouvrel, Jean-Paul, F-84500 Bollene (FR)
(74) Mandataire: Monnier, Guy

(56) Documents cités:
- EP-A- 0 021 269
- WO-A-92/17745
- DE-A- 3 026 167
- DE-A- 3 740 233
- DE-U- 9 100 864
- US-A- 5 016 090

## Description

La présente invention a trait aux échangeurs de chaleur destinés à être associés aux composants électroniques et autres appareillages électrotechniques.

Les échangeurs de ce type connus en pratique sont généralement constitués par deux pièces métalliques relativement massives dans lesquelles est usiné un chenal en forme de serpentin. On comprend que la circulation d'un liquide caloporteur à travers le serpentin assure bien l'échange thermique, c'est-à-dire l'évacuation, ou au contraire l'apport, de calories propres à opérer le maintien du composant électronique à la température souhaitée. Le document DE-U- 91 00 864 décrit un échangeur de chaleur conventionnel.

On conçoit néanmoins que la réalisation de tels échangeurs est relativement coûteuse par suite de la complexité tant des opérations d'usinage des pièces que de celles impliquées par leur assemblage. Par ailleurs, l'usinage fixe une surface d'échange limitée et une perte de charge importante. Ce mode de fabrication est particulièrement rigide, en ce sens qu'il est très difficile, dans le cadre d'une même fabrication, de faire varier la capacité d'échange thermique et les performances hydrauliques du dispositif.

C'est à ces inconvénients qu'entend principalement remédier la présente invention, laquelle consiste à empiler et à braser de minces flasques ajourés entre deux couvercles, le brasage assurant le maintien, la liaison thermique et l'herméticité des pièces constitutives. Deux embouts latéraux permettent le raccordement de l'échangeur au circuit de fluide.

On comprend qu'un tel échangeur présente, sous un faible encombrement, une surface d'échange thermique très élevée. Par ailleurs, la modification des caractéristiques d'échange est susceptible d'être très aisément modifiée puisqu'il suffit de faire varier le nombre de flasques ajourés, la structure de ceux-ci et des couvercles restant identique.

Le dessin annexé, donné à titre d'exemple, permettra de mieux comprendre l'invention, les caractéristiques qu'elle présente et les avantages qu'elle est susceptible de procurer :

Fig. 1 est une vue en perspective d'un échangeur thermique réalisé conformément à l'invention.

Fig. 2 illustre la constitution de l'échangeur suivant fig. 1.

Fig. 3 est une coupe schématique du dispositif au niveau de l'un des embouts de raccordement.

Fig. 4 est une coupe suivant le plan indiqué en IV-IV sur la fig. 3, le plan de coupe de cette dernière apparaissant en III-III en fig. 4.

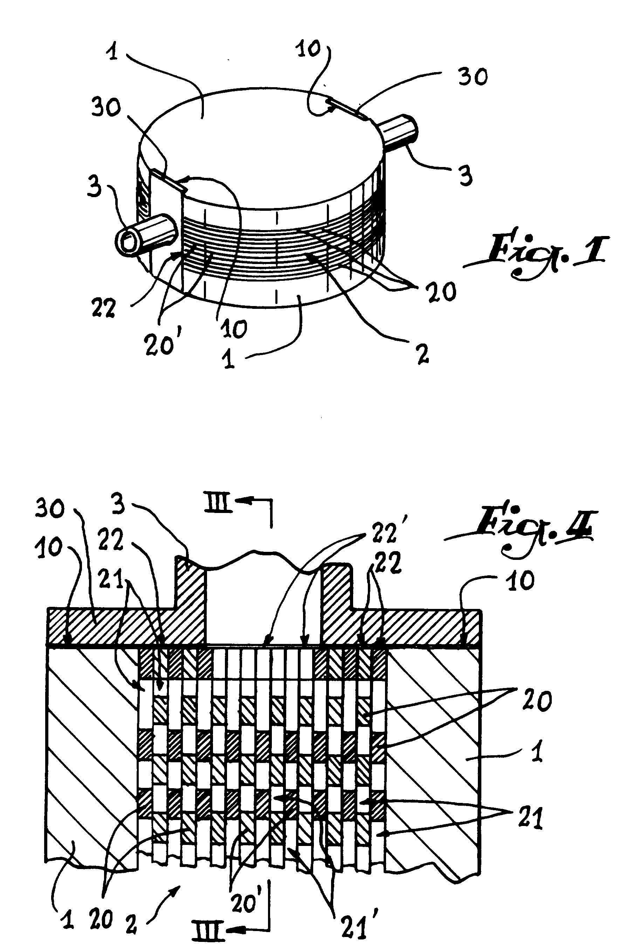

L'échangeur représenté en fig. 1 se présente sous la forme d'un boîtier, à profil cylindrique dans l'exemple de réalisation envisagé. Ce boîtier comprend deux couvercles opposés 1 entre lesquels vient se loger une enveloppe 2 complétée par deux embouts de raccordement 3, diamétralement opposés l'un à l'autre dans le cas considéré.

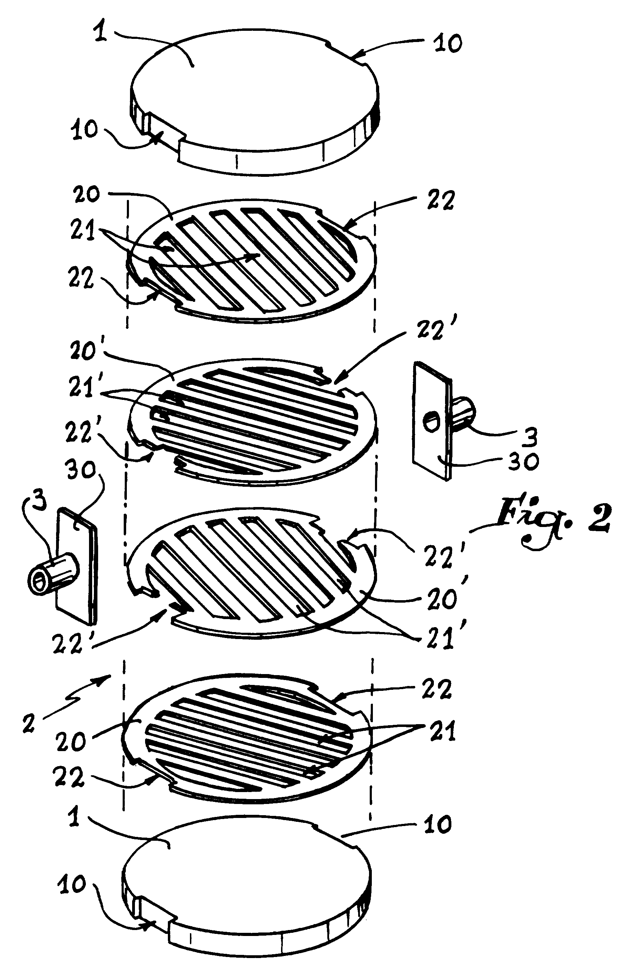

Comme illustré en fig. 2, l'enveloppe 2 est formée par un empilage de flasques ajourés 20, présentant une épaisseur réduite. Chaque flasque 20 est obtenu par découpage d'un feuillard plan en un métal tel que le cuivre, l'aluminium ou un alliage, l'une au moins des faces de ce feuillard étant revêtue d'une couche superficielle de brasure.

Il convient d'observer que les ajours ménagés dans chaque flasque 20 lors du découpage de celui-ci définissent une série d'ouvertures allongées 21 orientées parallèlement les unes aux autres. Par ailleurs, chaque flasque 20 comporte deux entailles 22 diamétralement opposées l'une à l'autre, l'axe qui relie ces deux entailles 22 étant orienté obliquement par rapport à l'axe des ouvertures 21. On notera encore que sur certains, référencés 20', des flasques, chacune des deux entailles 22' débouche dans l'ouverture 21' qui lui est adjacente.

La longueur de chaque entaille 22 ou 22' est égale, à un très léger jeu près, à la largeur d'une bride 30 solidaire de chacun des deux embouts de raccordement 3 ; la hauteur de cette bride 30 est substantiellement égale à celle du boîtier, les couvercles 1 étant eux-mêmes entaillés en 10.

Pour la constitution de l'empilage qui forme l'enveloppe 2 du boîtier, on réalise tout d'abord deux ensembles identiques dont chacun comprend le même nombre de flasques 20, en prenant soin de disposer par retournement lesdits flasques par paires dans chacune desquelles les ouvertures 21 se coupent les unes les autres. Entre les deux ensembles ainsi constitués vient s'insérer un troisième formé par des flasques 20' eux-mêmes disposés par paires croisées, de la même manière que les flasques 20. Les deux embouts 3 sont présentés de façon à ce que leur bride 30 vienne s'encastrer dans les entailles 10, 22 et 22', une pastille de brasure étant interposée entre ladite bride et le fond des entailles précitées.

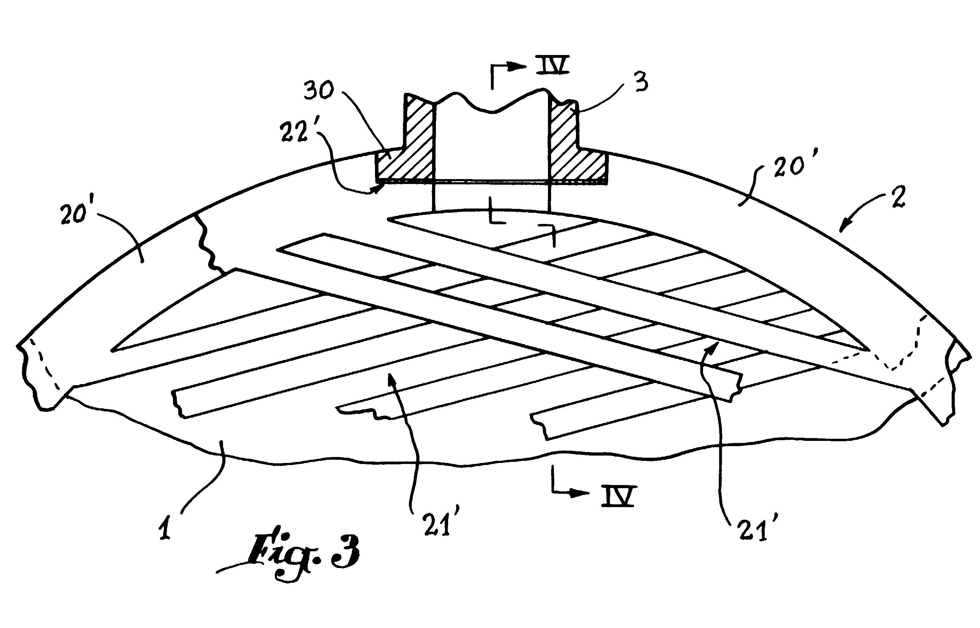

Les pièces ainsi disposées sont alors soumises à une opération de brasage sous vide et sous pression, de sorte qu'on obtient finalement le boîtier monobloc tel que représenté en fig. 1, 3 et 4, le brasage assurant l'étanchéité au niveau de la périphérie et la solidarisation des flasques sur toute leur surface. L'espace interne de chaque embout 3 se trouve orienté suivant l'axe des entailles 22' de sorte que le liquide caloporteur qui alimente l'échangeur peut pénétrer dans le boîtier à travers l'un desdits embouts, circuler à travers les ouvertures ou ajours 21 et 21' des flasques, et sortir à travers l'embout 3 opposé après avoir cédé ses calories au boîtier et au composant porté par celui-ci, ou au contraire après avoir apporté auxdits boîtier et composant les calories nécessaires au conditionnement thermique souhaité.

Fig. 4 fait bien apparaître que l'entrecroisement des ouvertures 21 et 21' des flasques détermine pour le fluide de conditionnement un circuit en chicanes qui assure, par suite de la grande surface d'échange, des performances particulièrement élevées sous un encombrement remarquablement réduit.

Il va de soi que les embouts 3 sont susceptibles d'être fixés sur le boîtier de façon à ce que leurs axes se trouvent décalés l'un par rapport à l'autre ; en certains cas, ces embouts peuvent être rendus solidaires, non plus de l'enveloppe 2 formée par l'empilage de flasques, mais de l'un et/ou l'autre des deux couvercles latéraux 1, le fluide traversant alors ledit empilage perpendiculairement au plan de celui-ci.

Les ajours présentés par les flasques peuvent être prévus de manière asymétrique, en vue de favoriser le conditionnement thermique de certaines zones au détriment d'autres. Ces ajours sont bien entendu susceptibles de présenter tout profil approprié.

Il va de soi que les flasques et les couvercles sont susceptibles de présenter tout profil polygonal désiré.

## Revendications

1. Echangeur de chaleur pour composants électroniques et autres appareillages électro-techniques, comprenant un boîtier dont l'une au moins des faces est destinée à être en contact avec le composant ou l'appareillage, tandis que son espace intérieur est parcouru par un fluide caloporteur entre deux embouts de raccordement (3) portés par le boîtier, dans lequel le boîtier est formé par deux couvercles latéraux (1) caractérisé en ce que entre les deux couvercles latéraux est brasé un empilage de flasques minces (20,20') ajourés, les ajours (21, 21') étant profilés et orientés de façon à permettre le passage en chicanes du fluide caloporteur entre les embouts.

2. Echangeur suivant la revendication 1, caractérisé en ce que chaque embout (3) est solidaire d'une bride (30) apte à venir s'encastrer à l'intérieur d'entailles (10, 22, 22') prévues au niveau de la périphérie des flasques (20, 20') et des couvercles (1).

3. Echangeur suivant la revendication 2, caractérisé en ce que les entailles (22') des flasques (20') qui sont destinés à se trouver disposés en vis-à-vis des embouts (3) sont pratiquées de manière à déboucher dans l'ajour adjacent (21') desdits flasques.

4. Echangeur suivant l'une quelconque des revendications 1 à 3, caractérisé en ce que les ajours (21, 21') présentent un profil allongé orienté obliquement par rapport à l'axe des deux embouts (3), les flasques (20, 20') étant tournés de façon à ce que les ajours de deux flasques adjacents se croisent.

## Patentansprüche

1. Wärmetauscher für elektronische Bauteile und andere elektro-technische Geräte, mit einem Gehäuse, von dem wenigstens eine der Seiten dazu bestimmt ist, mit dem Bauteil oder mit dem Gerät in Verbindung zu stehen, während sein Innenraum von einer Kühlflüssigkeit durchströmt wird, und zwar zwischen zwei am Gehäuse vorgesehen Anschlußstücken (3), das zwischen zwei seitlichen Deckeln (1) gebildet ist, **dadurch gekennzeichnet**, daß zwischen den beiden seitlichen Deckeln eine Schichtung dünner durchbrochener Platten (20, 20') eingelötet sind, und wobei die Durchbrüche (21, 21') derart ausgebildet und ausgerichtet sind, daß sie eine Durchflußschikane für die Kühlflüssigkeit zwischen den Ansatzstücken bilden.

2. Wärmetauscher nach Anspruch 1, **dadurch gekennzeichnet**, daß jeder Anschluß (3) mit einem Riegel (30) verbunden ist, der dazu bestimmt ist, sich in das Innere der Ausnehmung (10, 22, 22'), die im Bereich des Umfanges der dünnen Platten (20, 20') und dem Deckel (1) vorgesehen sind, einzufügen.

3. Wärmetauscher nach Anspruch 2, **dadurch gekennzeichnet**, daß die Ausnehmungen (22') der dünnen Platten (20'), die dazu bestimmt sind, die gegenüberliegenden Anschlußstücke (3) in sich zu halten, zweckentsprechend zu dem angrenzenden Durchbruch (21') besagter Platten geöffnet sind.

4. Wärmetauscher gemäß einem der Ansprüche 1 bis 3, **dadurch gekennzeichnet**, daß die Durchbrüche (21, 21') eine länglich-gesteckte Form aufweisen, die schräg zu den Achsen beider Anschlußstücke (3) ausgerichtet sind, wobei die dünnen Platten (20, 20') derart verdreht zueinander sind, daß die Durchbrüche zweier benachbarter Platten sich kreuzen.

## Claims

1. A heat-exchanger for electronic components and other electrotechnical apparatus, comprising a casing, at least one of the faces of which is intended to be in contact with the component or the apparatus, whereas the inner space thereof is traversed by a heat-transfer fluid between two connecting end pieces (3) borne by the casing, in which the casing is formed by two lateral covers (1), characterised in that between the two lateral covers there is soldered a stack of thin perforated plates (20, 20'), the perforations (21, 21') being profiled and oriented so as to permit the heat-transfer fluid to pass in a baffled path between the end pieces.

2. An exchanger according to Claim 1, characterised in that each end piece (3) is integral with a flange (30) capable of embedding within notches (10, 22, 22') provided on the periphery of the plates (20, 20') and the covers (1).

3. An exchanger according to Claim 2, characterised in that the notches (22') of the plates (20') which are intended to be arranged opposite the end pieces (3) are made so as to open into the adjacent perforation (21') of said plates.

4. An exchanger according to any one of Claims 1 to 3, characterised in that the perforations (21, 21') have an elongate profile oriented obliquely relative to the axis of the two end pieces (3), the plates (20, 20') being turned such that the perforations of two adjacent plates cross each other.
